# EUROPEAN PATENT APPLICATION

(11) **EP 3 916 070 A1**
(43) Date of publication of application: **01.12.2021**
(21) Application number: 20177385.0
(22) Date of filing: 29.05.2020
(51) Int. Cl.: C09K 11/02, C09K 11/06, C09K 11/61, C09K 11/66, H01L 33/50

(54) **SOLID POLYMER COMPOSITION, A SELF-SUPPORTING FILM AND A LIGHT EMITTING DEVICE**

(71) Applicant: Avantama AG, 8712 Stäfa (CH)
(72) Inventor: LÜCHINGER, Norman, 8706 Meilen (CH)
(74) Representative: Rey, Antje Gabriele

(57) **Abstract**

The invention refers in a first aspect to a solid polymer composition 100 comprising green luminescent perovskite crystals 1, non-perovskite red phosphor particles 2, and a polymer 3. The polymer has a molar ratio of the sum of (oxygen + nitrogen) to carbon z, wherein z ≤ 0.9, z ≤ 0.75 in particular z ≤ 0.4, in particular z ≤ 0.3, in particular z ≤ 0.25.

A second aspect of the invention refers to a self-supporting film comprising the solid polymer composition 100.

A third aspect of the invention refers to a light emitting device comprising either the solid polymer composition 100 or the self-supporting film.

## Description

### Technical Field

The invention relates in a first aspect to a solid polymer compositon and in a second aspect to a self-supporting film as well as in a third aspect to a light emitting device.

### Background Art

State-of-the-art liquid crystal displays (LCD) or display components comprise luminescent crystal (quantum dot) based components. In particular, a backlight component of such a LCD might comprise a RGB backlight consisting of a red, a blue and a green light. Today, typically luminescent crystals (quantum dots) are used to produce the backlight colours of such a backlight component.

The manufacturing of such components faces various challenges. One challenge is the embedding of the luminescent crystals into the component. Due to the different chemical properties of the luminescent crystals, there might be incompatibilities between the various embedded materials comprising the luminescent crystals or even between luminescent crystals embedded within the same material. Such incompatibilities might lead to degradation of the materials in the display components and therefore the lifetime of such a display might be affected.

### Disclosure of the Invention

The problem to be solved by the present invention is to provide a material composition that overcomes the disadvantages of the prior art.

The present invention will be described in detail below. Unless otherwise stated, the following definitions shall apply in this specification:
The terms "a", "an" "the" and similar terms used in the context of the present invention are to be construed to cover both the singular and plural unless otherwise in-dicated herein or clearly contradicted by the context. The term "containing" shall include all, "comprising", "essentially consisting of" and "consisting of". Percentages are given as weight-%, unless otherwise indicated herein or clearly contradicted by the context. "Independently" means that one substituent / ion may be selected from one of the named substituents / ions or may be a combination of more than one of the above.

The term **"phosphor"** is known in the field and relates to materials that exhibits the phenomenon of luminescence, specifically fluorescent materials. Accordingly, a red phosphor is a material showing luminescence in the range of 610 - 650 nm, e.g. centered around 630 nm. Accordingly, a green phosphor is a material showing luminescence in the range of 500 - 550 nm, e.g. centered around 530 nm. Typically, phosphors are inorganic particles. The term **"phosphor particles"** means particles of the phosphor as described above. The particles can be single crystalline or polycrystalline. In the context of the present invention, the term particles refers to primary particles, not secondary particles (e.g. agglomerates or conglomerates of primary particles)

The term **"luminescent crystal"** (LC) is known in the field and relates to crystals of 3-100 nm, made of semiconductor materials. The term comprises quantum dots, typically in the range of 2 - 15 nm and nanocrystals, typically in the range of more than 15 nm and up to 100 nm (preferably up to 50 nm). Preferably, luminescent crystals are approximately isometric (such as spherical or cubic). Particles are considered approximately isometric, in case the aspect ratio (longest : shortest direction) of all 3 orthogonal dimensions is 1 - 2. Accordingly, an assembly of LCs preferably contains 50 - 100 % (n/n), preferably 66 - 100 % (n/n) much preferably 75 - 100 % (n/n) isometric nanocrystals.

LCs show, as the term indicates, luminescence. In the context of the present invention the term luminescent crystal includes both, single crystals and polycrystalline particles. In the latter case, one particle may be composed of several crystal domains (grains), connected by crystalline or amorphous phase boundaries. A luminescent crystal is a semiconducting material which exhibits a direct bandgap (typically in the range 1.1 - 3.8 eV, more typically 1.4 - 3.5 eV, even more typically 1.7 - 3.2 eV). Upon illumination with electromagnetic radiation equal or higher than the bandgap, the valence band electron is excited to the conduction band leaving an electron hole in the valence band. The formed exciton (electron-electron hole pair) then radiatively recombines in the form of photoluminescence, with maximum intensity centered around the LC bandgap value and exhibiting photoluminescence quantum yield of at least 1 %. In contact with external electron and electron hole sources LC could exhibit electroluminescence.

The term **"perovskite crystals"** is known and particularly includes crystalline compounds of the perovskite structure. Such perovskite structures are known per se and described as cubic, pseudocubic, tetragonal or orthorhombic crystals of general formula M1M2X3, where M1 are cations of coordination number 12 (cuboctaeder) and M2 are cations of coordination number 6 (octaeder) and X are anions in cubic, pseudocubic, tetragonal or orthorhombic positions of the lattice. In these structures, selected cations or anions may be replaced by other ions (stochastic or regularly up to 30 atom-%), thereby resulting in doped perovskites or nonstochiometric perovskites, still maintaining its original crystalline structure. The manufacturing of such luminescent crystals is known, e.g. from WO2018 028869.

The term **"polymer"** is known and includes organic synthetic materials comprising repeating units ("monomers"). The term polymers includes homo-polymers and co-polymers. Further, cross-linked polymers and non-cross-linked polymers are included. Depending on the context, the term polymer shall include its monomers and oligomers. Polymers include, by way of example, acrylate polymers, carbonate polymers, sulfone polymers, epoxy polymers, vinyl polymers, urethane polymers, imide polymers, ester polymers, furane polymers, melamine polymers, styrene polymers, norbornene polymers, silicone polymers and cyclic olefin copolymers. Polymers may include, as conventional in the field, other materials such as polymerization initiators, stabilizers, solvents, scattering particles.

Polymers may be further characterized by physical parameters, such as polarity, glass transition temperature Tg, Young's modulus and light transmittance.

Polarity (z): The ratio of heteroatoms (i.e. atoms other than carbon and hydrogen) to carbon (n/n) is an indicator for polymer polarity. In the context of this invention, polymers with 0.4 < z < 0.9 are considerd polar, while poymers with z ≤ 0.4 are considered apolar.

Glass transition temperature: (Tg) is a well-established parameter in the field of polymers; it describes the temperature where an amorphous or semi-crystalline polymer changes from a glassy (hard) state to a more pliable, compliant or rubbery state. Polymers with high Tg are considered "hard", while polymers with low Tg are considered "soft". On a molecular level, Tg is not a discrete thermodynamic transition, but a temperature range over which the mobility of the polymer chains increase significantly. The convention, however, is to report a single temperature defined as the mid-point of the temperature range, bounded by the tangents to the two flat regions of the heat flow curve of the DSC measurement. Tg may be determined according to DIN EN ISO 11357-2 or ASTM E1356 using DSC. This method is particularly suitable if the polymer is present in the form of bulk material. Alternatively, Tg may be deter-mined by measuring temperature-dependent micro- or nanohardness with micro- or nanoindentation according to ISO 14577-1 or ASTM E2546-15. This method is suited for luminescent components and lighting devices as disclosed herein. Suitable analytical equipment is available as MHT (Anton Paar), Hysitron TI Premier (Bruker) or Nano Indenter G200 (Keysight Technologies). Data obtained by temperature controlled micro- and nanoindentation can be converted to Tg. Typically, the plastic deformation work or Young's modulus or hardness is measured as a function of temperature and Tg is the temperature where these parameters change significantly.

Young's modulus or Young modulus or Elasticity modulus is a mechanical property that measures the stiffness of a solid material. It defines the relationship between stress (force per unit area) and strain (proportional deformation) in a material in the linear elasticity regime of a uniaxial deformation.

Transmittance: Typically, polymers used in the context of this invention are light transmissive for visible light, i.e. non-opaque for allowing light emitted by the luminescent crystals, and possible light of a light source used for exciting the luminescent crystals to pass. Light transmittance may be determinded by white light interferometry or UV-Vis spectrometry.

According to the present invention, the above described problem is solved by **a first aspect** of the invention, a solid polymer composition comprising a first class of luminescent materials, selected from green luminescent perovskite crystals, a second class of luminescent materials, selected from non-perovskite red phosphor particles and a polymer. Suitable green luminescent perovskite crystals are selected from compounds of formula (I):

[M¹A¹]ₐM²_{b}X_{c} (I),

wherein:
A¹ represents one or more organic cations, preferably formamidinium,
M¹ represents one or more alkaline metals, in particular Cs,
M² represents one or more metals other than M1, in particular Pb,
X represents one or more anions selected from the group consisting of halides, pseudohalides and sulfides, in particular Br,
a represents 1-4,
b represents 1-2,
c represents 3-9, and
   wherein either M¹, or A¹, or M¹ and A¹ being present.

Suitable non-perovskite red phosphor particles are Mn+4 doped phosphor particules are selected from compounds of formula (II):

[A]ₓ[MF_{y}]:Mn⁴⁺ (II),

wherein:
A represents Li, Na, K, Rb, Cs or a combination thereof, in particular K,
M represents Si, Ge, Sn, Ti, Zr, Al, Ga, In, Sc, Y, La, Nb, Ta, Bi, Gd, or a combination thereof, in particular Si
x represents an absolute value of the charge of the [MFy] ion, in particular 2; and
Y represents 5, 6 or 7, in particular 6.

The polymer has a molar ratio of the sum of (oxygen + nitrogen) to carbon z, wherein z ≤ 0.9, z ≤ 0.75 in particular z ≤ 0.4, in particular z ≤ 0.3, in particular z ≤ 0.25.

A solid polymer composition comprising specific green luminescent crystals, specific non-perovskite red Mn4+-doped phosphors and specific polymer matrices, enables high stability of the luminescent crystals and the non-perovskite red phosphors when used in light emitting devices, in particular in LCD displays.

In particular, formula (I) describes perovskite luminescent crystals which, upon absoprption of blue light emit light of a wavelength in the green light spectrum between 500 nm and 550 nm, in particular centred around 527 nm.

In an advantageous embodiment, the green luminescent perovskite crystals are in particular green luminescent perovskite crystals of the formula (I'):

FAPbBr₃ (I').

In a further advantageous embodiment of the invention, the non-perovskite red phosphor particles are non-perovskite red phosphor Mn+4 doped phosphor particles of formula (II'):

K2SiF6:Mn4+ (II').

In an advantageous embodiment of the solid polymer composition, the green luminescent perovskite crystals and the non-perovskite red phosphor particles are embedded into the polymer.

In particular, the green luminescent perovskite crystals and the non-perovskite red phosphor particles are both distributed within the polymer and in particular are essentially distributed within the polymer such that they do not exceed a surface of the polymer.

In a further advantageous embodiment of the invention, the polymer has a molar ratio of the sum of (oxygen + nitrogen + sulphur + phosphorous + fluorine + chlorine + bromine + iodine) to carbon z < 0.9, preferably z < 0.4, preferably z < 0.3, most preferably z < 0.25.

In a further advantageous embodiment of the solid polymer composition, the difference in concentration Δc_{Mn} of Mn between the center of each non-perovskite red phosphor particle and an area 100 nm below the particle surface is Δc_{Mn} ≤ 50%, in particular Δc_{Mn} ≤ 20%.

The center of the particle refers in particular to a center area of the particle, in particular a core or core region of the particle.

In contrast to known red phosphor particles, the non-perovskite red phosphor particles as introduced in this invention do advantageously not comprise an inorganic protection layer on the surface. In particular, the non-perovskite red phosphor particles do not comprise a meta-loxide or K₂SiF₆ protection layer.

For an advantageous embodiment, the omission of the inorganic protection layer might be implemented as following, wherein the suggested embodiments might be independent from each other or might be combined:
- Advantageously, the non-perovskite red phosphor particles are free of an inorganic surface coating. In particular, the particles are free of inorganic surface coating with a composition that differes from the composition of a core of each non-perovskite red phosphor particle. Free of an inorganice surface coating means in particular that there is essentially no such coating present on the respective surface.
- Advantageously, each non-perovskite red phosphor particicles exhibits a homogenous distribution of Mn+4 from the particle center to the particle surface. Therefore, in particular, each non-perovskite red phosphor particular has an essentially homogenous concentration C_{Mn} of Mn over the whole volume of the respective particle.
- Advantageously, the non-perovskite red phosphor particles have a Manganese (Mn) -concentration C_{Mn} of C_{Mn} ≥ 6 mol%, in particular of C_{Mn} ≥ 9 mol%, in particular of C_{Mn} ≤ 11 mol %.
Without being bound to theory, it is believed that, in contrast to known non-perovskite red phosphor particles that need an inorganic layer for stabilization, the polymer matrix here provides the stability.

In a further advantageous embodiment of the invention, the non-perovskite red phosphor particles have a Mn-concentration C_{M} of 6 ≤ C_{M} ≤ 15 mol%, preferably 10 ≤ C_{M} ≤ 14 mol%, most preferably 11 ≤ C_{M} ≤ 13 mol%.

Advantageously, the non-perovskite red phosphor particles hava a particle size Sₚ of Sₚ ≤ 10 µm, advantageously of Sₚ ≤ 5 µm, advantageously of Sₚ ≤ 2 µm, advantageously of Sₚ ≤ 1 µm, advantageously of Sₚ ≥ 50 nm, advantageously of Sₚ ≥ 100 nm, advantageously of Sₚ ≥ 200nm.

In an advantageous embodiment, the solid polymer composition comprises an acrylate, very advantageously the polymer comprises a cyclic aliphatic acrylate. I

In another advantageous embodiment, the solid polymer comprises a multi-functional acrylate.

In another advantageous embodiment, the solid polymer is cross-linked. Cross linking may be achieved as known in the field, e.g. by adding cross-linking agents or multivalent monomers.

An advantageous solid polymer composition has a glass transition temperature T_{g} of T_{g} ≤ 120°C, advantageously of T_{g} ≤ 100°C, advantageously of T_{g} ≤ 80°C, advantageously of T_{g} ≤ 70°C. Each T_{g} is measured according to DIN EN ISO 11357-2:2014-07 during the second heating cycle and applying a heating rate of 20K/min, starting at -90°C up to 250°C.

In a further advantageous embodiment of the invention, the solid polymer composition comprises scattering particles selected from the group consisting of metal oxide particles and polymer particles. Advantageously, the particles are metal oxide particles, preferably selected from the group consisiting of TiO₂, ZrO₂, Al₂O₃ and organopolysiloxanes.

In a further advantageous embodiment the solid polymer is semicrystalline.

In a further advantageous embodiment the solid polymer has a melting temperature Tₚ of Tₚ < 140°C, preferably Tₚ < 120°C, most preferably Tₚ < 100°C.

The inventive solid polymer compositions may be obtained in analogy to known methods using the starting materials of formula (I), formula (II) and monomers / oligomers of the respective polymer. The invention thus provides for a method of manufacturing a solid polymer composition comprising the steps of
(a) combining compound of formula (I), compound of formula (II), monomer and/or oligomer of the polymer, optionally diluent, optionally scattering particles, optionally catalyst or other additives, to thereby obtain a first dispersion;
(b) optionally removing the diluent to thereby obtain an ink;
(d) curing said ink to thereby obtain the inventive solid polymer composition.

A **second aspect** of the invention refers to a self-supporting film that comprises a solid polymer composition according to the first aspecet of the invention.

Advantageously, the self-supporting film emits green and red light in response to excitation by light of a wavelength shorter than the emitted green light.

Advantageously, the the solid polymer composition is sandwiched between two barrier layers.

In a further advantageous embodiment, such a self-supporting film can have a thickness t_{ssf} of 0.001 ≤ t_{ssf} ≤ 10 mm, preferably of 0.01 ≤ t_{ssf} ≤ 0.5 mm.

In a further advantageous embodiment, the solid polymer is sandwiched between two barrier layers. In particular, such sandwich arrangement refers to an arrangement in a horizontal direction with a barrier layer, the polymer and another barrier layer. The two barrier layers of the sandwich structure can be made of the same barrier layer material or of different barrier layer materials.

The technical effect of the barrier layers is to improve the stability of the luminescent perovskite crystals, in particular against oxygen or humidity.

In particular, such **barrier layers** are known in the field; typically comprising a material / a combination of materials with low water vapour transmission rate (WVTR) and / or low oxygen transmission rate (OTR). By selecting such materials, the degradation of the LCs in the component in response to being exposed to water vapor and / or oxygen is reduced or even avoided. Barrier layers or films preferably have a WVTR < 10 (g) / (m^2*day) at a temperature of 40°C / 90% r.h. and atmospheric pressure, more preferably less than 1 (g)/(m^2*day), and most preferably less than 0.1 (g)/(m^2*day).

In an advantageous embodiment, the barrier film may be permeable for oxygen. In another advantageous embodiment, the barrier film is impermeable for oxygen and has an OTR (oxygen transmission rate) < 10 (mL)/(m^2*day) at a temperature of 23°C / 90% r.h. and atmospheric pressure, more preferably < 1 (mL)/(m^2*day), most preferably < 0.1 (mL) / (m^2*day).

In one embodiment, the barrier film is transmissive for light, i.e. transmittance for visible light > 80%, preferably > 85%, most preferably > 90%.

Suitable barrier films may be present in the form of a single layer. Such barrier films are known in the field and contain glass, ceramics, metal oxides and polymers. Suitable polymers may be selected from the group consisting of polyvinylidene chlorides (PVdC), cyclic olefin copolymer (COC), ethylene vinyl alcohol (EVOH), high-density polyethylene (HDPE), and polypropylene (PP); suitable inorganic materials may be selected from the group consisting of metal oxides, SiOx, SixNy, AlOx. Most preferably, a polymer humidity barrier material contains a material selected from the group of PVdC and COC.

Advantageously, a polymer oxygen barrier material contains a material selected from EVOH polymers.

Suitable barrier films may be present in the form of multilayers. Such barrier films are known in the field and generally comprise a substrate, such as PET with a thickness in the range of 10 - 200 µm, and a thin inorganic layer comprising materials from the group of SiOx and AlOx or an organic layer based on liquid crystals which are embedded in a polymer matrix or an organic layer with a polymer having the desired barrier properties. Possible polymers for such organic layers com-prise for example PVdC, COC, EVOH.

The inventive self-supporting films may be obtained in analogy to known methods using the starting materials of formula (I), formula (ii) and monomers / oligomers of the respective polymer. The invention thus provides for a method of manufacturing a self-supporting film, comprising the steps of
(a) combining compound of formula (I), compound of formula (II), monomer and/or oligomer of the polymer, optionally diluent, optionally scattering particles, optinally catalyst or other additives, to thereby obtain a first dispersion;
(b) optionally removing the diluent to thereby obtain an ink;
c) coating said ink on a barrier film to thereby obtain a coated barrier film;
(d) laminating said coated barrier film with a second barrier film
(e) curing said laminated barrier films to thereby obtain the inventive self-supproting film;

The inventive manufacturing is simple and can be easily applied to existing production lines.

A **third aspect** refers to a light emitting device which is preferably a liquid crystal display. The light emitting device comprises a solid polymer composition according to the first aspect of the invention or a self-supporting film according to the second aspect of the invention.

An advantageous embodiment of the light emitting devive comprises an array of more than one blue LED, wherein the array of LEDs covers essentially the full liquid crystal display area. In addition, a diffusor plate is arranged between the array of more than one blue LED and the self-supporting film.

In a further advantageous embodiment of the invention, the one or more blue LEDs of the array are each adapted to switch between on and off with a frequency f of f ≥ 150 Hz, preferably of f ≥ 300 Hz, very preferably of f ≥ 600 Hz.

### Brief Description of the Drawings

The invention will be better understood and objects other than those set forth above will become apparent from the following detailed description thereof. Such description makes reference to the annexed drawings, wherein:
Fig. 1 shows a schematic of a solid polymer composition according to an embodiment of the invention;
Fig. 2 shows a schematic of a sheet-like material according to an embodiment of the invention; and
Fig. 3 shows a light emitting device according to an embodiment of the invention.

### Modes for Carrying Out the Invention

Embodiments, examples, experiments representing or leading to embodiments, aspects and advantages of the invention will be better understood from the following detailed description thereof. Such description makes reference to the annexed drawings, wherein:

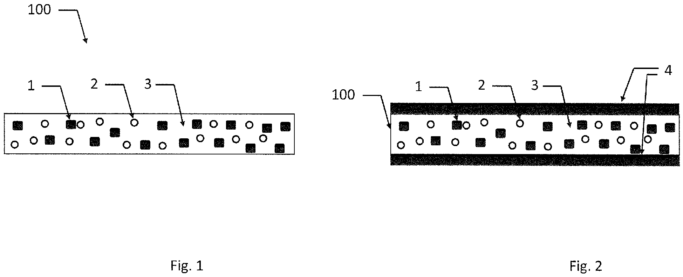

Fig. 1 shows a schematic of a solid polymer composition 100 according to an embodiment of the first aspect, wherein the solid polymer composition comprieses green luminescent perovskite crystals 1 of formula (I), non-perovskite red phosphor crystals 2 of formula (II), and a polymer 3. The polymer has a molar ratio of the sum of (oxygen + nitrogen) to carbon z, wherein z ≤ 0.9, z ≤ 0.75 in particular z ≤ 0.4, in particular z ≤ 0.3, in particular z ≤ 0.25.
   Further embodiments of the solid polymer composition in Fig. 1 might comprise further features according to the first aspect of the invention.
Fig. 2 shows a schematic of an embodiment of a self-supporting film according to the second aspect of the invention. In an advantageous embodiment as demonstrated in the figure, the self-supporting film might comprise barrier layers 4 that sandwich the solid polymer composition 100.

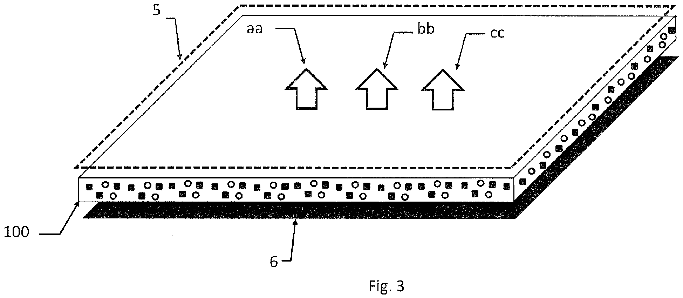

Fig. 3 shows a schematic of an embodiment of a light emitting device, in particular a liquid crystal display (LCD) according to the third aspect of the invention. Advantageously, the light emitting device comprises a solid polymer composition 100 as shown in Fig. 1 or a self-supporting film as shown in Fig. 2. Advantageously, the light emitting device comprises more than one blue LED 6, wherein the LEDs covers essentially the full liquid crystal display area 5. In particular, a diffusor plate is arranged between the array of more than one blue LED and the self-supporting film (the diffusor plate is not shown in the figure).

### Experimental Section

**Example 1:** Preparation of a self-supporting film comprising a solid polymer composition as described herein:
**Green perovskite QDs (FAPbBr₃):** Formamidinium lead tribromide (FAPbBr₃) was synthesized by milling PbBr₂ and FABr. Namely, 16 mmol PbBr₂ (5.87 g, 98% ABCR, Karlsruhe (DE)) and 16 mmol FABr (2.00 g, Greatcell Solar Materials, Queanbeyan, (AU)) were milled with Yttrium stabilized zirconia beads (5 mm diameter) for 6 h to obtain pure cubic FAPbBr₃, confirmed by XRD. The orange FAPbBr₃ powder was added to Oleylamine (80-90, Acros Organics, Geel (BE)) (weight ratio FAPbBr₃:Oleylamine = 100:15) and toluene (>99.5 %, puriss, Sigma Aldrich). The final concentration of FAPbBr₃ was 1wt %. The mixture was then dispersed by ball milling using yttrium stabilized zirconia beads with a diameter size of 200 µm at ambient conditions (if not otherwise defined, the atmospheric conditions for all experiments are: 35°C, 1 atm, in air) for a period of 1h yielding an ink with green luminescence.

**Film formation:** 0.1 g of the green ink was mixed with an UV curable monomer/crosslinker mixture (0.7 g FA-513AS, Hitachi Chemical, Japan / 0.3 g Miramer M240, Miwon, Korea) containing 1wt% photoinitiator Diphenyl(2,4,6-trimethylbenzoyl) phosphine oxide (TCI Europe, Netherlands) and 2 wt% polymeric scattering particles (Organopolysiloxane, ShinEtsu, KMP-590) and 10 wt% non-perovskite red phosphor particles (K₂SiF₆:Mn₄₊) in a speed mixer and the toluene was evaporated by vacuum (<0.01 mbar) at room temperature.

The resulting mixture was then coated with 50 micron layer thickness on a 100 micron barrier film (supplier: I-components (Korea); Product: TBF-1007), then laminated with a second barrier film of the same type. Afterwards the laminate structure was UV-cured for 60 s (UVAcube100 equipped with a mercury lamp and quartz filter, Hoenle, Germany) to thereby obtain a self-supporting film wherein the inventive solid polymer composition is sandwiched between two barrier layers.

**Performance Tests:** The initial performance of the as obtained film showed a green emission wavelength of 526 nm with a FWHM of 22 nm and a red emission wavelength characteristic for K₂SiF₆:Mn₄₊. The color coordinates (CIE1931) of the film were x = 0.23 and y = 0.20 when placed on a blue LED light source (450 nm emission wavelength) with two crossed prism sheets (X-BEF) and one brightness enhancement film (DBEF) on top of the QD film (optical properties measured with a Konica Minolta CS-2000) .

The glass transition temperature Tg of the UV-cured solid polymer composition was determined by DSC according to DIN EN ISO 11357-2:2014-07 with a starting temperature of -90°C and an end temperature of 250°C and a heating rate of 20 K/min in nitrogen atmosphere (20 ml/min). The purging gas was nitrogen (5.0) at 20 ml/min. The DSC system DSC 204 F1 Phoenix (Netzsch) was used. The T_{g} was determined on the second heating cycle (the first heating from -90°C to 250°C showed overlaying effects besides the glass transition). For the DSC measurement the solid polymer composition was removed from the film by delaminating the barrier films. The measured Tg of the UV-cured resin composition was 75°C.

The stability of the film was tested for 150 hours under blue LED light irradiation by placing the film into a light box with high blue intensity (supplier: Hoenle; model: LED CUBE 100 IC) with a blue flux on the film of 410 mW/cm² at a film temperature of 50°C. Furthermore the film was also tested for 150 hours in a climate chamber with 60°C and 90% relative humidity. The change of optical parameters after stability testing of the film for was measured with the same procedure as for measuring the initial performance (described above). The change of optical parameters were as following:

| test condition | x-value (-) | y-value (-) | Luminanance (%) |
|---|---|---|---|
| initial | 0.23 | 0.20 | 100% |
| 150h high flux (410 mW/cm²) | 0.23 | 0.19 | 95% |
| 150h 60°C/90% r.H. | 0.23 | 0.19 | 93% |

**Conclusion:** These results show that a self-supporting luminescent film could be obtained whereby the green provskite crystals and non-perovskite red phosphor particles (K₂SiF₆:Mn₄₊) both show a good chemical compatibility and high stability when tested under high blue flux and high temperature/humidity.

## Claims

1. A solid polymer composition (100) comprising
- green luminescent perovskite crystals (1),
- non-perovskite red phosphor particles (2), and
- a polymer (3),
wherein the green luminescent perovskite crystals (1) are selected from compounds of formula (I):
[M¹A¹]ₐM²_{b}X_{c} (I),
wherein:
A¹ represents one or more organic cations, in particular formamidinium,
M¹ represents one or more alkaline metals, in particular Cs,
M² represents one or more metals other than M1, in particular Pb,
X represents one or more anions selected from the group consisting of halides, pseudohalides and sulfides, in particular Br,
a represents 1-4,
b represents 1-2,
c represents 3-9, and
wherein either M¹, or A¹, or M¹ and A¹ being present;
wherein the non-perovskite red phosphor particles (2) are Mn+4 doped phosphor particles of formula (II) :
[A]ₓ[MF_{y}]:Mn⁴⁺ (II),
wherein:
A represents Li, Na, K, Rb, Cs or a combination thereof, in particular K,
M represents Si, Ge, Sn, Ti, Zr, Al, Ga, In, Sc, Y, La, Nb, Ta, Bi, Gd, or a combination thereof, in particular Si,
x represents the absolute value of the charge of the [MFy] ion, in particular 2; and
Y represents 5, 6 or 7, in particular 6,
; and
wherein the polymer (3) has a molar ratio of the sum of (oxygen + nitrogen) to carbon z, wherein z ≤ 0.9, z ≤ 0.75 in particular z ≤ 0.4, in particular z ≤ 0.3, in particular z ≤ 0.25.

2. The solid polymer composition (100) according to claim 1, wherein the green luminescent perovskite crystals (1) are of formula (I'):
FAPbBr₃ (I').

3. The solid polymer composition (100) according to one of the preceding claims, wherein the non-perovskite red phosophor particles (2) are Mn+4 doped phosphor particles of formula (II'):
K₂SiF₆:Mn⁴⁺ (II').

4. The solid polymer composition (100) according to one of the preceding claims, wherein a difference in concentration Δc_{Mn} of Mn between the center of each non-perovskite red phosphor particle (2) and an area 100 nm below the respective red phosphor particle surface is ΔC_{Mn} ≤ 50%, in particular Δc_{Mn} ≤ 20%.

5. The solid polymer composition (100) according to one of the preceding claims 1 to 3, wherein the concentration C_{Mn} of Mn in each non-perovskite red phosphor particle (2) is essentially homogenously over the volume of the respective non-perovskite red phosphor particle.

6. The solid polymer composition (100) according to one of the preceding claims wherein the non-perovskite red phosphor particles (2) are free of an inorganic surface coating, in particular are free of an inorganic surface coating with a composition that differs from the composition of a core of each non-perovskite red phosphor particle (2).

7. The solid polymer composition (100) according to one of the preceding claims wherein the non-perovskite red phosphor particles (2) have a Mn-concentration C_{Mn} of C_{Mn} ≥ 6 mol%, in particular of C_{Mn} ≥ 9 mol%, in particular of C_{Mn} ≥ 11 mol%.

8. The solid polymer composition (100) according to one of the preceding claims wherein the non-perovskite red phosphor particles (2) have a particle size Sₚ of Sₚ ≤ 10 µm, in particular of Sₚ ≤ 5 µm, in particular of Sₚ ≤ 2 µm, in particular of Sₚ ≤ 1 µm, and in particular Sₚ ≥ 50 µm, in particular Sₚ ≥ 100 µm, in particular Sₚ ≥ 200nm.

9. The solid polymer composition (100) according to one of the preceding claims, wherein the polymer (3) comprises an acrylate, very particular wherein the polymer comprises a cyclic aliphatic acrylate.

10. The solid polymer composition (100) according to one of the preceding claims, wherein the solid polymer composition (100) has a glass transition temperature T_{g} of T_{g} ≤ 120°C, in particular of T_{g} ≤ 100°C, in particular of T_{g} ≤ 80°C, in particular of T_{g} ≤ 70°C.

11. The solid polymer composition (100) according to one of the preceding claims, wherein the solid polymer composition (100) comprises scattering particles selected from the group consisting of metal oxide particles and polymer particles, preferably selected from the group consisting of TiO2, ZrO2, Al2O3 and organopolysiloxanes.

12. A self-supporting film comprising a solid polymer composition (100) according to claim 1 to 11.

13. The self-supporting film according to claim 12, wherein the solid polymer composition (100) is sandwiched between two barrier layers (4).

14. A light emitting device, in particular a liquid crystal display (LCD),
comprising a solid polymer composition (100) according to claims 1 to 11,
or
comprising a self-supporting film according to claim 12 or 13.

15. The light emitting device according to claim 14 comprising an array of more than one blue LED (6),
wherein the array of LEDs (6) covers essentially the full liquid crystal display area (5), and
wherein a diffusor plate is arranged between the array of more than one blue LED (6) and the self-supporting film.
